# EUROPEAN PATENT SPECIFICATION

(11) **EP 4 641 608 B1**
(45) Date of publication and mention of the grant of the patent: **19.08.2026**
(21) Application number: 25170930.9
(22) Date of filing: 16.04.2025
(51) Int. Cl.: H01H 47/18, H01H 47/04

(54) **LOW POWER RELAY DRIVING DEVICE AND METHOD, AND LOW POWER RELAY DEVICE**
NIEDRIGLEISTUNGSRELAISANSTEUERUNGSVORRICHTUNG UND -VERFAHREN SOWIE NIEDRIGLEISTUNGSRELAISVORRICHTUNG
DISPOSITIF ET PROCÉDÉ DE COMMANDE DE RELAIS DE FAIBLE PUISSANCE, ET DISPOSITIF DE RELAIS DE FAIBLE PUISSANCE

(30) Priority: 23.04.2024 KR 20240054202
(43) Date of publication of application: 29.10.2025
(73) Proprietor: Hanwha Solutions Corporation, Jung-gu Seoul 04541 (KR)
(72) Inventor: SIM, Ju Young, 04541 Seoul (KR)
(74) Representative: Mooser, Sebastian Thomas

(56) References cited:
- WO-A1-96/10262
- US-A- 4 720 762
- US-A1- 2022 285 116
- US-B2- 9 336 976

## Description

### BACKGROUND

### 1. Field

The present disclosure relates to a low-power relay driving device and method, and a low-power relay device.

### 2. Description of the Related Art

In order to drive a power relay, a high voltage that is referred to as a pickup voltage has to be supplied so that a coil of a relay may form a strong magnetic force. US-B-9336976 discloses a prior art relay driving device.

Although a power relay can remain operational because contacts are maintained even with a relatively low voltage after the contacts are closed, continuous supply of a pickup voltage may cause a high relay power consumption, and thus, a method of reducing a relay power consumption is necessary.

The above-mentioned background technology is technical information that the inventor possessed for deriving the present invention or acquired in the process of deriving the present invention, and cannot necessarily be said to be known art disclosed to the general public before filing the application for the present invention.

### SUMMARY

The invention is set out in the appended claims.

One or more embodiments of the present disclosure provide a low-power relay driving device and method, and a low-power relay device. It will be appreciated by one of ordinary skill in the art that the objectives and effects that could be achieved with the present disclosure are not limited to what has been particularly described above and other objectives and advantages of the present disclosure will be more clearly understood from the following detailed description and embodiments of the present disclosure. Also, it will be readily understood that the objects and advantages of the present disclosure are realized by the means and combinations thereof set forth in the appended claims.

According to a first aspect of the present disclosure, provided is a low-power relay driving device including a signal generation module configured to generate a driving signal with respect to a relay including a coil and a switching element, a first switching element connected to the signal generation module and the relay, a second switching element connected between the first switching element and the relay, and connected to a resistor in parallel so as to adjust a voltage applied to the relay, a third switching element connected to the second switching element and configured to control opening/closing of the second switching element, a fourth switching element connected to the third switching element and configured to control opening/closing of the third switching element, and a time-delay module connected between the fourth switching element and the signal generation module and allowing the fourth switching element to be closed later than a point in time when the first switching element is closed.

According to a second aspect of the present disclosure, provided is a low-power relay driving method including driving a first switching element in a closed state in response to a driving signal generated by a signal generation module, driving a fourth switching element in an open state, based on a time-delay module not transferring the driving signal to the fourth switching element for a certain time duration after a point in time when the driving signal is generated, based on that the fourth switching element is in open state, driving a third switching element in a closed state, driving a second switching element in a closed state, and receiving, by a relay, a first voltage, driving the fourth switching element in a closed state in response to that the time-delay module transfers the driving signal to the fourth switching element after a certain time duration has passed, and based on that the fourth switching element is in the closed state, driving the third switching element in an open state, driving the second switching element in an open state, and receiving, by the relay, a second voltage that is less than the first voltage.

According to a third aspect of the present disclosure, provided is a low-power relay device including a relay including a coil and a switching element, and a driver circuit that is connected to the relay, drives in a first driving state for a certain time duration after a point in time when a driving signal is received and drives in a second driving state after the certain time duration has passed, and applies a first voltage to the relay during the first driving state and applies a second voltage to the relay during the second driving state, wherein the second voltage is less than the first voltage.

Other aspects, features and advantages other than those described above will become apparent from the following detailed description of the drawings, claims and disclosure.

### BRIEF DESCRIPTION OF THE DRAWINGS

The above and other aspects, features, and advantages of certain embodiments of the disclosure will be more apparent from the following description taken in conjunction with the accompanying drawings in which:
FIG. 1 is a circuit diagram for describing a relay device according to an embodiment of the present disclosure;
FIG. 2 is a circuit diagram for describing a current flow in a relay driving device in an initial state according to an embodiment of the present disclosure;
FIG. 3 is a circuit diagram for describing a current flow in a relay driving device in a first driving state according to an embodiment of the present disclosure;
FIG. 4 is a circuit diagram for describing a current flow in a relay driving device in a second driving state according to an embodiment of the present disclosure;
FIG. 5 is a diagram for describing changes in a voltage and current applied to a relay connected to a relay driving device according to an embodiment of the present disclosure; and
FIG. 6 is a flowchart for describing an example of a low-power relay driving method performed by a relay driving device according to an embodiment of the present disclosure.

### DETAILED DESCRIPTION

The disclosure will be described in detail below with reference to accompanying drawings.

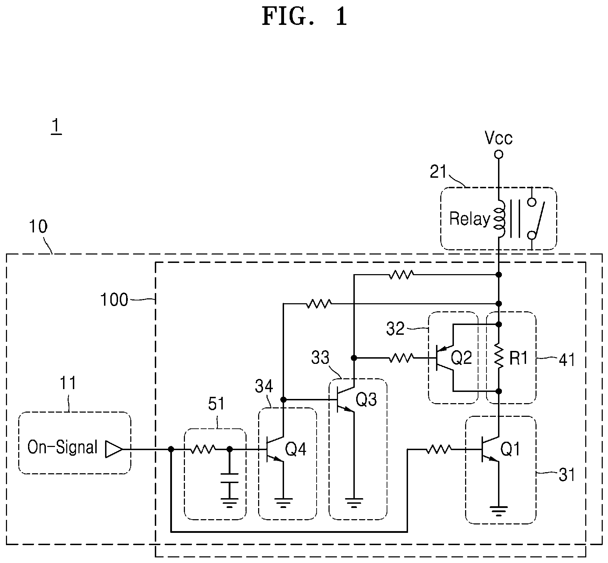

FIG. 1 is a circuit diagram for describing a relay device according to an embodiment of the present disclosure.

Referring to FIG. 1, a low-power relay device 1 according to an embodiment of the present disclosure may include a relay driving device 10 and a relay 21.

In an embodiment, the relay driving device 10 may include a signal generation module 11, a first switching element 31, a second switching element 32, a third switching element 33, a fourth switching element 34, one or more resistors 41, and a time-delay module 51. The relay driving device 10 of the present disclosure is connected to the relay 21 and may control the driving of the relay 21.

The signal generation module 11 may denote a component generating a driving signal with respect to the relay 21. Based on the driving signal generated by the signal generation module 11, the relay 21 may be activated or deactivated. Alternatively, the signal generation module 11 may denote a component providing a power source for operating the relay 21. In response to the supply of power from the signal generation module 11, the relay 21 may generate a magnetic field and operate a switch, as described later.

The relay 21 may denote a component that controls driving (e.g., turning-on or turning-off) of another circuit connected thereto, in response to the driving signal generated by the signal generation module 11. In the present disclosure, another circuit connected to the relay 21 is not particularly restricted. The relay 21 may include a coil and one or more switching elements.

The coil (or relay coil) (not shown) included in the relay 21 may form a magnetic field in response to the supply of current from the circuit connected to the relay 21. Here, the circuit connected to the relay 21 may denote a driver circuit 100 including the first switching element 31, the second switching element 32, the third switching element 33, the fourth switching element 34, one or more resistors 41, and the time-delay module 51. In other words, a power or supply voltage Vcc provided by the signal generation module 11 may be supplied to the coil (not shown) via the driver circuit 100.

A switching element (not shown) included in the relay 21 may drive in response to the magnetic field formed by the coil. In the present disclosure, driving of the switching element may denote that the switching element is in a closed state, and on the contrary, not driving of the switching element may denote that the switching element is in an open state.

In an embodiment of the present disclosure, the driver circuit 100 may include the first switching element 31, the second switching element 32, the third switching element 33, the fourth switching element 34, the one or more resistors 41, and the time-delay module 51.

In an embodiment, each of the switching elements included in the driver circuit 100 may be implemented as a bipolar junction transistor (BJT). For example, each switching element may be an NPN-type BJT or a PNP-type BJT. For example, according to a circuit configuration method of the relay driving device, one of the switching elements (e.g., the second switching element) as shown in FIG. 1 may be implemented as a PNP-type BJT.

In another embodiment, each of the switching elements included in the driver circuit 100 may be implemented as a metal oxide semiconductor field effect transistor (MOSFET). In some embodiments, the implementation type of the switching elements included in the driver circuit 100 is not limited to the embodiments of the present disclosure.

In some embodiments, the time-delay module 51 included in the driver circuit 100 in an embodiment may include a resistor and a capacitor. In another embodiment, the time-delay module 51 may include an inductor and a resistor. In some embodiments, the implementation type of the time-delay module 51 included in the driver circuit 100 may not be limited to a resistor-capacitor (RC) circuit or an inductor-capacitor (LC) circuit.

In addition, the first switching element 31 may be connected to the signal generation module 11 and the relay 21.

In more detail, the first switching element 31 may be connected to the signal generation module 11 in series. In an embodiment, when the first switching element 31 is implemented as a BJT, a base of the BJT may be connected to the signal generation module 11. In addition, as in the example of the relay driving device 10 shown in FIG. 1, another element such as a resistor, etc. may be additionally connected between the first switching element 31 and the signal generation module 11.

In some embodiments, the first switching element 31 may be connected to the fourth switching element 34 in parallel. As such, the first switching element 31 and the fourth switching element 34 may simultaneously receive the driving signal from the signal generation module 11. In other words, the first switching element 31 and the fourth switching element 34 may drive simultaneously in open states, in response to the driving signal.

The second switching element 32 may be connected to the first switching element 31. In more detail, the second switching element 32 may be connected between the first switching element 31 and the relay 21. In an embodiment, when the second switching element 32 and the first switching element 31 are implemented as BJTs, a collector of the second switching element 32 and a collector of the first switching element 31 may be connected to each other.

The second switching element 32 may be connected to the resistor 41 in parallel. In other words, the resistor 41 may be also connected between the first switching element 31 and the relay 21.

In an embodiment, when the first switching element 31 drives in a closed state, the first switching element 31 may apply the supplied current to the relay 21 via the second switching element 32 or the resistor 41. For example, when the second switching element 32 drives in a closed state, the current may be supplied to the relay 21 via the second switching element 32, and when the second switching element 32 drives in an open state, the current may be supplied to the relay 21 via the resistor 41. In other words, based on the driving state of the second switching element 32, the resistor connected to the relay 21 in series may be added or excluded. This may denote that the voltage supplied to the relay 21 may be adjusted based on the driving state of the second switching element 32.

The fourth switching element 34 may be connected to the signal generation module 11. In some embodiments, the fourth switching element 34 may be connected to the first switching element 31 in parallel. That is, as described above, the fourth switching element 34 may receive the driving signal simultaneously with the first switching element 31.

In an embodiment, the time-delay module 51 may be connected between the fourth switching element 34 and the signal generation module 11. In an embodiment, when the fourth switching element 34 is implemented as the BJT, the base of the fourth switching element 34 and the time-delay module 51 may be connected to each other.

Due to the time-delay module 51, the fourth switching element 34 may receive the driving signal generated by the signal generation module 11 after a certain time duration has passed.

In other words, the time-delay module 51 may adjust (delay the time) the time of transmitting the driving signal so that the fourth switching element 34 may drive in a closed state later than the first switching element 31. In some embodiments, as described later, the time-delay module 51 may delay the time so that the second switching element 32 may drive in an open state after the point in time when the first switching element 31 drives in the closed state.

The fourth switching element 34 may be connected to the third switching element 33. In detail, the fourth switching element 34 may be connected to the third switching element 33 in the form of controlling the driving state of the third switching element 33. For example, the driving state of the third switching element 33 may be changed based on the driving state of the fourth switching element 34.

In an embodiment, when the fourth switching element 34 and the third switching element 33 are implemented as the BJTs, a collector of the fourth switching element 34 and a base of the third switching element 33 may be connected to each other. In some embodiments, the fourth switching element 34 may be connected to a resistor (not shown) that is in parallel with the third switching element 33 and may control the driving state of the third switching element 33.

The third switching element 33 may be connected to the second switching element 32. In detail, the third switching element 33 may be connected to the second switching element 32 in the form of controlling the driving state of the second switching element 32. For example, the driving state of the second switching element 32 may be changed based on the driving state of the third switching element 33.

In an embodiment, when the third switching element 33 and the second switching element 32 are implemented as BJTs, a collector of the third switching element 33 and a base of the second switching element 32 may be connected to each other. In some embodiments, in an embodiment, a resistor may be additionally connected between the collector of the third switching element 33 and the base of the second switching element 32.

In some embodiments, the third switching element 33 may be connected between the second switching element 32 and the fourth switching element 34. This may denote that the time delay due to the time-delay module 51 may also affect the second switching element 32 through the fourth switching element 34 and the third switching element 33. For example, based on the driving state of the third switching element 33, the second switching element 32 may drive in the open state after the point in time when the first switching element 31 drives in the closed state.

In addition, the relay driving device 10 (or driver circuit 100) according to an embodiment of the present disclosure may drive in an initial state before the signal generation module 11 applies a driving signal thereto.

In some embodiments, the relay driving device 10 (or driver circuit 100) may drive in a first driving state for a certain time duration after the point in time when receiving the driving signal from the signal generation module 11. Here, the certain time duration may denote the time duration taken for the fourth switching element to receive the driving signal (or power) generated by the signal generation module 11. In other words, as described later, the fourth switching element is not immediately closed due to the time-delay module 51, and the certain time duration may denote the time taken for the fourth switching element to be closed after receiving the driving signal from the signal generation module 11.

In some embodiments, the relay driving device 10 (or driver circuit 100) may drive in the second driving state after a certain time duration has passed.

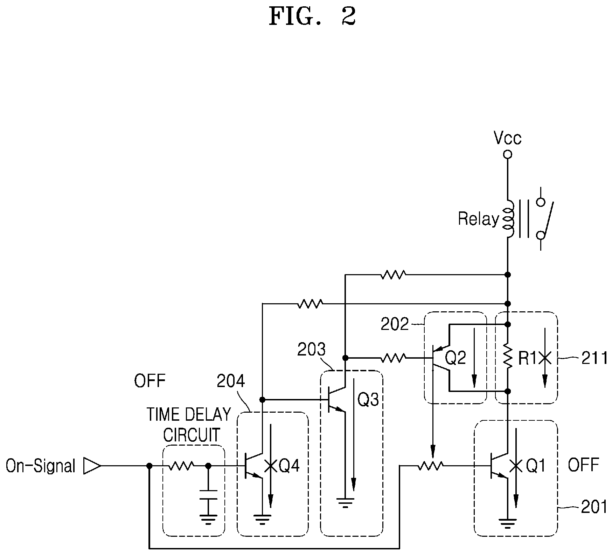

Hereinafter, examples of driving the components included in the relay driving device 10 according to the driving state of the relay driving device 10 (or driver circuit 100) are described with reference to FIGS. 2 to 5.

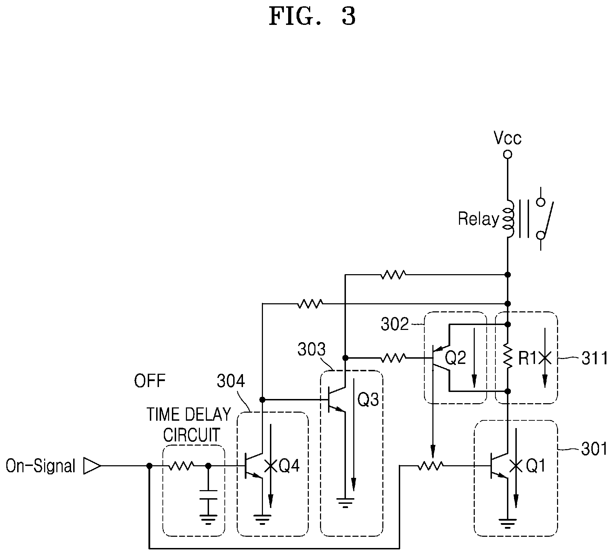

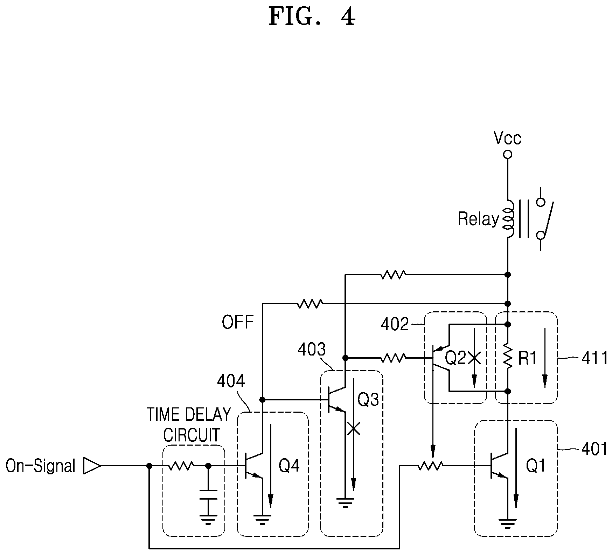

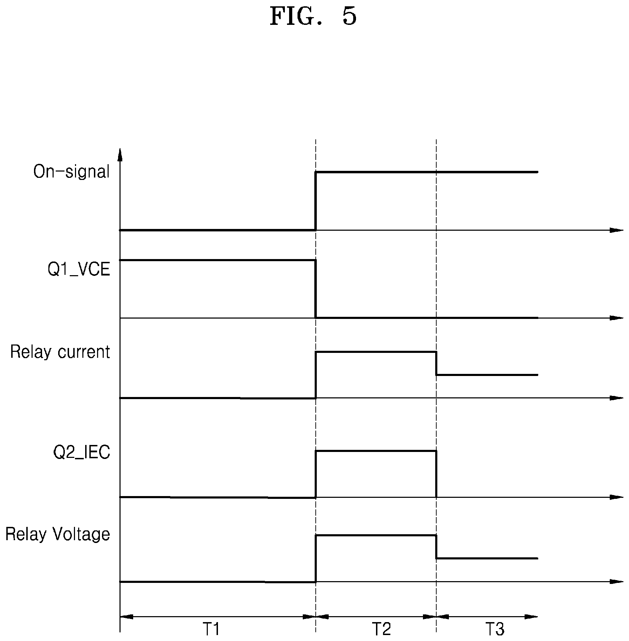

FIG. 2 is a circuit diagram for describing a current flow in the relay driving device in an initial state according to an embodiment of the disclosure, FIG. 3 is a circuit diagram for describing a current flow in the relay driving device in a first driving state according to an embodiment of the present disclosure, and FIG. 4 is a circuit diagram for describing a current flow in the relay driving device in a second driving state according to an embodiment of the present disclosure. FIG. 5 is a diagram for describing changes in a voltage and current applied to a relay connected to a relay driving device according to an embodiment of the present disclosure.

First, referring to FIG. 2, in the initial state, a first switching element 201 and a fourth switching element 204 may drive in open states.

In an embodiment, when the first switching element 201 and the fourth switching element 204 are implemented as the BJTs, both the first switching element 201 and the fourth switching element 204 may drive in the open state based on a potential difference between a base and an emitter.

A third switching element 203 may drive in a closed state in an initial state.

In an embodiment, when the third switching element 203 is implemented as a BJT, the supply voltage (Vcc voltage) is supplied to a base of the third switching element 203 via a resistor connected to the third switching element 203 to form a base current, and thus, the third switching element 203 may drive in the closed state.

A second switching element 202 may drive in a closed state in an initial state.

In an embodiment, when the second switching element 202 is implemented as a PNP-type BJT, a positive voltage between the emitter and the base may be supplied based on that the third switching element 203 drives in the closed state, and accordingly, the second switching element 202 may drive in the closed state.

Referring to FIG. 5, in a section where the relay driving device drives in the initial state (section T1), a current and voltage may not be supplied to the relay.

In the section T1, the first switching element 201 is in an open state, and thus, a voltage applied between the collector and the emitter may have a large value close to the supply voltage (Vcc voltage).

In the section T1, the second switching element 202 is in the closed state and the first switching element 201 is in the open state, and thus, the current flowing between the emitter and collector of the second switching element 202 may have a small value close to 0 A.

Referring to FIG. 3, in a first driving state, a first switching element 301 may drive in a closed state. In other words, the first switching element 301 is in an ON-state, and the current may flow between a collector and an emitter.

A fourth switching element 304 may drive in an open state in the first driving state. In an embodiment of the present disclosure, the fourth switching element 304 may be maintained in the open state even in the first driving state due to a time-delay module.

A third switching element 303 may drive in a closed state in the first driving state. Like in the initial state, the third switching element 303 may be maintained in the closed state during the first driving state because the fourth switching element 304 drives in the open state.

The second switching element 302 may drive in a closed state in the first driving state.

Like in the initial state, the second switching element 302 may be maintained in the closed state in the first driving state, because the third switching element 303 drives in the closed state.

In addition, because the second switching element 302 drives in the closed state in the first driving state, a current does not flow in a resistor 311. In other words, a supply voltage Vcc is not distributed to the resistor 311.

As such, a voltage corresponding to a value of *Vcc - Vec*(*Q*2) *- Vce*(*Q*1) may be supplied to a coil of a relay according to an embodiment.

Referring to FIG. 5, in a section in which the relay driving device drives in the first driving state (section T2), a current and voltage are supplied to the coil of the relay. For convenience of description, the current and voltage supplied to the coil of the relay in the first driving state are defined as a first current and a first voltage, and a current and voltage supplied to the coil of the relay in a second driving state are defined as a second current and a second voltage. Descriptions about comparison between the first current and the second current and comparison between the first voltage and the second voltage are provided later.

Referring to FIG. 5, in section T2, the first switching element 301 drives in the closed state, and thus, a voltage applied between the collector and emitter has a small value close to 0.

In some embodiments, in section T2, the second switching element 302 drives in the closed state and the first switching element 301 is also in closed state, and thus, the current flowing between an emitter and a collector of the second switching element 302 may have a maximum value.

Referring to FIG. 4, a first switching element 401 in a second driving state may drive in a closed state. In other words, the first switching element 401 is in ON-state like in the first driving state, and the current may flow between a collector and an emitter.

A fourth switching element 404 may drive in a closed state in the second driving state. After a time duration delayed by the time-delay module has passed, the fourth switching element 404 may drive in a closed state in response to a driving signal.

A third switching element 403 may drive in an open state in the second driving state.

In an embodiment, according to the fourth switching element 404 closed in the second driving state, the supply voltage Vcc may not be supplied to a base of the third switching element 403. Accordingly, a potential difference may not be generated between a base and an emitter of the third switching element 403, and thus, the third switching element 430 is opened. In other words, the third switching element 403 is in an OFF-state, and the current does not flow between the collector and the emitter.

A second switching element 402 may drive in an open state in the second driving state.

In an embodiment, according to the third switching element 430 opening in the second driving state, a negative voltage may be supplied between an emitter and a base of the second switching element 402. Accordingly, the second switching element 402 is opened. In other words, the second switching element 402 is in an OFF-state, and the current does not flow between the collector and the emitter.

In addition, because the second switching element 402 drives in the open state in the second driving state, the current flows in a resistor 411. In other words, the supply voltage Vcc may be distributed to the resistor 411.

As such, in the second driving state according to an embodiment, a coil of a relay is supplied with a part of the supply voltage Vcc while sharing with the resistor 411.

That is, when the first voltage corresponds to a value *Vcc - Vec*(*Q*2) *- Vce*(*Q*1), the first voltage has a value close to Vcc (supply voltage), whereas the second voltage is part of Vcc (supply voltage) as described above, and thus, the second voltage may have a value less than the first voltage.

Consequently, referring to the graph of FIG. 5, the second voltage and the second current respectively have less values than the first voltage and the first current.

According to an embodiment of the present disclosure, at an initial stage in which the relay driving device drives to supply the voltage to the relay, a voltage of the level of the supply voltage may be supplied to the coil of the relay. After that, after a certain time duration has passed and contacts of the relay are closed, a voltage of a lower level than the supply voltage may be supplied to the coil of the relay. As such, the relay driving device of the present disclosure may supply the voltage to the coil of the relay even after the contacts of the relay are closed, and moreover, may reduce the power consumption of the relay by supplying a lower voltage.

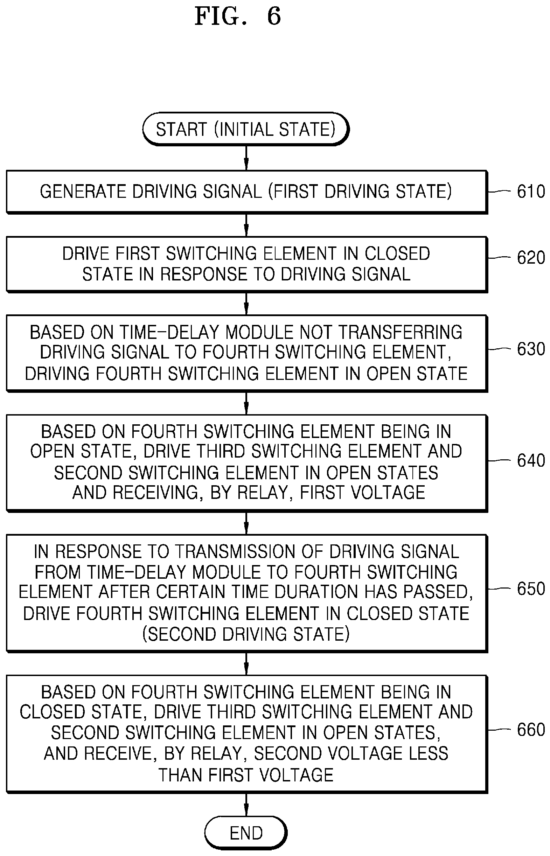

FIG. 6 is a flowchart for describing an example of a low-power relay driving method, performed by a relay driving device, according to an embodiment of the present disclosure.

Hereinafter, a relay device, a relay, a relay driving device, and a driver circuit described below with reference to FIG. 6 may be the same as the relay device, the relay, the relay driving device, and the driver circuit described above with reference to FIGS. 1 to 5. Therefore, redundant descriptions are omitted.

Frist, in operation 610, the relay driving device may generate a driving signal for the relay. For example, a signal generation module included in the relay driving device may generate the driving signal.

In an embodiment, the relay driving device may drive in an initial state before generating the driving signal, and may drive in the first driving state after generating the driving signal.

In operation 620, the first switching element may drive in the closed state in response to the driving signal generated by the signal generation module.

In an embodiment, the first switching element drives in the open state in the initial state, but may drive in the closed state in the first driving state.

In operation 630, based on that the time-delay module does not transmit the driving signal to the fourth switching element for a certain time duration from the point in time when the driving signal is generated, the fourth switching element may drive in the open state.

In an embodiment, the time-delay module connected between the fourth switching element and the signal generation module may allow the fourth switching element may be closed later than the point in time when the first switching element is closed.

In an embodiment, the fourth switching element may drive in the open state in the initial state and the first driving state due to the time-delay by the time-delay module.

In operation 640, based on that the fourth switching element is in the open state, the third switching element and the second switching element may drive in the closed states and the relay may receive the supply of first voltage.

In an embodiment, the fourth switching element may be connected to the third switching element so as to control the opening/closing of the third switching element, and the third switching element may be connected to the second switching element so as to control the opening/closing of the second switching element.

In an embodiment, based on that the fourth switching element is in the open state, the third switching element and the second switching element may drive in the closed state even in the first driving state, like in the initial state.

In an embodiment, the relay connected to the relay driving device may receive the supply of first voltage during the first driving state.

In operation 650, after a certain time duration has passed from the point in time when the driving signal is generated, in response to the transmission of the driving signal from the time-delay module to the fourth switching element, the fourth switching element may drive in the closed state.

In an embodiment, the relay driving device may drive in the first driving state for a certain time duration from the point in time when receiving the driving signal, and after the certain time duration has passed, the relay driving device may drive in the second driving state.

In an embodiment, the first switching element may drive in the open state in the first driving state, and may drive in the closed state in the second driving state.

In operation 660, based on that the fourth switching element is in the closed state, the third switching element and the second switching element may drive in the open state, and the relay may receive the supply of the second voltage that is less than the first voltage.

In an embodiment, based on that the fourth switching element is in the closed state, the third switching element and the second switching element may drive in the open state in the second driving state, unlike in the first driving state.

In an embodiment, the time-delay module may allow the second switching element to be opened after the point in time when the first switching element is closed.

In an embodiment, the relay may receive the supply voltage after dividing the supply voltage with the resistor that is connected to the second switching element in parallel, in response to that the second switching element drives in the open state. Accordingly, the second voltage received by the relay in the second driving state may have a value less than the first voltage supplied in the first driving state.

According to an embodiment of the present disclosure, the relay driving device may initially apply the first voltage to the relay so that the contacts are closed in the relay according to the relay driving signal, and then may apply the voltage less than the first voltage to the relay, after the contacts in the relay are closed, so as to reduce the power consumption.

An embodiment of the present disclosure may be embodied in the form of a computer program that may be run in and/or executed by a computer through various elements, and the computer program may be recorded on a non-transitory computer-readable recording medium. Examples of the non-transitory computer-readable recording medium include, but are not limited to, magnetic media (e.g., hard disks, floppy disks, and magnetic tapes), optical media (e.g., CD-ROMs and DVDs), magneto-optical media (e.g., floptical disks), and hardware devices specifically configured to store and execute program commands (e.g., ROMs, RAMs, and flash memories).

Meanwhile, the computer programs may be specially designed or well known to one of ordinary skill in the computer software field. Examples of the computer programs may include not only machine language code but also high-level language code which is executable by various computing means by using an interpreter.

According to an embodiment, the method according to various embodiments disclosed in the present disclosure may be provided to be included in a computer program product. The computer program product may be traded between a seller and a buyer as a product. The computer program product may be distributed in the form of a machine-readable storage medium e.g., compact disc read only memory (CD-ROM)), or be distributed (e.g., downloaded or uploaded) online via an application store (e.g., PlayStore^{™}), or between two user devices directly. If distributed online, at least part of the computer program product may be temporarily generated or at least temporarily stored in the machine-readable storage medium, such as memory of the manufacturer's server, a server of the application store, or a relay server.

According to the solution of the present disclosure, the voltage supplied to the coil of the relay is reduced after the contacts of the relay are closed, and thus, the power consumption of the relay may be reduced.

According to the solution of the present disclosure, the low-power relay driving circuit may be implemented by using circuit devices that are relatively simple, and thus, a system complexity and costs for configuring the system may be reduced.

## Claims

1. A low-power relay device (1) comprising: a relay (21) including a coil and
a switching element;
a signal generation module (11) configured to generate a driving signal; and a first switching element (31) connected to the signal generation module (11) and the relay (21);
**characterized in that**:
a second switching element (32) connected between the first switching element (31) and the relay (21), and connected to a resistor (41) in parallel so as to adjust a voltage applied to the relay (21);
a third switching element (33) connected to the second switching element (32) and
configured to control opening/closing of the second switching element (32);
a fourth switching element (34) connected to the third switching element (33) and
configured to control opening/closing of the third switching element (33);
and a time-delay module (51) connected between the fourth switching element (34) and the signal generation module (11) and allowing the fourth switching element (34) to be closed later than a point in time when the first switching element (31) is closed.

2. The low-power relay device of claim 1, wherein
the low-power relay device drives in an initial state before receiving the driving signal, drives in a first driving state for a certain time duration from a point in time when receiving the driving signal, and drives in a second driving state after the certain time duration has passed.

3. The low-power relay device of claim 2, wherein
the relay receives a first voltage during the first driving state, and receives a second voltage having a value less than the first voltage during the second driving state.

4. The low-power relay device of claim 2, wherein
the fourth switching element is open in the initial state and is open in the first driving state, and is closed in the second driving state.

5. The low-power relay device of claim 2, wherein
the first switching element is open in the initial state, is closed in the first driving state, and is closed in the second driving state.

6. The low-power relay device of claim 2, wherein
the third switching element is closed in the initial state, is closed in the first driving state, and is open in the second driving state.

7. The low-power relay device of claim 2, wherein
the second switching element is closed in the initial state, is closed in the first driving state, and is open in the second driving state.

8. The low-power relay device of claim 1, wherein
the time-delay module allows the second switching element to be opened after a point in time when the first switching element is closed.

9. A low-power relay driving method for driving the low-power relay device (1) of claim 1, the method comprising:
driving a first switching element (31) in a closed state in response to a driving signal generated by a signal generation module (11);
driving a fourth switching element (34) in an open state, based on a time-delay module (51) not transferring the driving signal to the fourth switching element (34) for a certain time duration after a point in time when the driving signal is generated;
based on that the fourth switching element (34) is in open state, driving a third switching element (33) in a closed state, driving a second switching element (32) in a closed state, and receiving, by a relay (21), a first voltage;
driving the fourth switching element (34) in a closed state in response to that the time-delay module (51) transfers the driving signal to the fourth switching element (34) after a certain time duration has passed; and
based on that the fourth switching element (34) is in the closed state, driving the third switching element (33) in an open state, driving the second switching element (32) in an open state, and receiving, by the relay (21), a second voltage that is less than the first voltage.

10. The low-power relay driving method of claim 9, wherein
the relay
receives a supply voltage by dividing the supply voltage with a resistor connected to the second switching element in parallel, in response to that the second switching element drives in an open state.

11. The low-power relay device of claim 1, wherein the device is configured to:
drive in a first driving state for a certain time duration after a point in time when the driving signal is received and drive in a second driving state after the certain time duration has passed, and
apply a first voltage to the relay during the first driving state and apply a second voltage to the relay during the second driving state,
wherein the second voltage is less than the first voltage.

## Patentansprüche

1. Relaisvorrichtung (1) mit geringem Stromverbrauch, umfassend: ein Relais (21) mit einer Spule und einem Schaltelement;
ein Signalgenerierungsmodul (11), das so konfiguriert ist, dass es ein Ansteuersignal erzeugt; und ein erstes Schaltelement (31), das mit dem Signalgenerierungsmodul (11) und dem Relais (21) verbunden ist;
**dadurch gekennzeichnet, dass**:
ein zweites Schaltelement (32), das zwischen dem ersten Schaltelement (31) und dem Relais (21) verbunden ist und parallel zu einem Widerstand (41) verbunden ist, um eine an das Relais (21) angelegte Spannung einzustellen;
ein drittes Schaltelement (33), das mit dem zweiten Schaltelement (32) verbunden und so konfiguriert ist, dass es ein Öffnen/Schließen des zweiten Schaltelements (32) steuert;
ein viertes Schaltelement (34), das mit dem dritten Schaltelement (33) verbunden und so konfiguriert ist, dass es ein Öffnen/Schließen des dritten Schaltelements (33) steuert; und
ein Zeitverzögerungsmodul (51), das zwischen dem vierten Schaltelement (34) und dem Signalgenerierungsmodul (11) verbunden ist und es ermöglicht, das vierte Schaltelement (34) später als zu einem Zeitpunkt zu schließen, zu dem das erste Schaltelement (31) geschlossen ist.

2. Relaisvorrichtung mit geringem Stromverbrauch nach Anspruch 1, wobei
die Relaisvorrichtung mit geringem Stromverbrauch in einem Anfangszustand vor einem Empfang des Ansteuersignals arbeitet, ab einem Zeitpunkt des Empfangs des Ansteuersignals für eine bestimmte Zeitdauer in einem ersten Ansteuerzustand arbeitet und nach Ablauf der bestimmten Zeitdauer in einem zweiten Ansteuerzustand arbeitet.

3. Relaisvorrichtung mit geringem Stromverbrauch nach Anspruch 2, wobei
das Relais während des ersten Ansteuerzustands eine erste Spannung empfängt und während des zweiten Ansteuerzustands eine zweite Spannung mit einem Wert empfängt, der kleiner ist als die erste Spannung.

4. Relaisvorrichtung mit geringem Stromverbrauch nach Anspruch 2, wobei
das vierte Schaltelement im Anfangszustand offen ist, im ersten Ansteuerungszustand offen ist und im zweiten Ansteuerungszustand geschlossen ist.

5. Relaisvorrichtung mit geringem Stromverbrauch nach Anspruch 2, wobei
das erste Schaltelement im Anfangszustand offen ist, im ersten Ansteuerungszustand geschlossen ist und im zweiten Ansteuerungszustand geschlossen ist.

6. Relaisvorrichtung mit geringem Stromverbrauch nach Anspruch 2, wobei
das dritte Schaltelement im Anfangszustand offen ist, im ersten Ansteuerungszustand geschlossen ist und im zweiten Ansteuerungszustand offen ist.

7. Relaisvorrichtung mit geringem Stromverbrauch nach Anspruch 2, wobei
das zweite Schaltelement im Anfangszustand geschlossen ist, im ersten Ansteuerungszustand geschlossen ist und im zweiten Ansteuerungszustand offen ist.

8. Relaisvorrichtung mit geringem Stromverbrauch nach Anspruch 1, wobei
das Zeitverzögerungsmodul es ermöglicht, das zweite Schaltelement nach einem Zeitpunkt zu öffnen, zu dem das erste Schaltelement geschlossen ist.

9. Verfahren zum Ansteuern eines Relay mit geringem Stromverbrauch zum Ansteuern der Relaisvorrichtung (1) mit geringem Stromverbrauch nach Anspruch 1, wobei das Verfahren umfasst:
Ansteuern eines ersten Schaltelements (31) in einen geschlossenen Zustand als Reaktion auf ein von einem Signalgenerierungsmodul (11) erzeugtes Ansteuersignal;
Ansteuern eines vierten Schaltelements (34) in einen offenen Zustand, basierend darauf, dass ein Zeitverzögerungsmodul (51) das Ansteuersignal für eine bestimmte Zeitdauer nach einem Zeitpunkt, zu dem das Ansteuersignal erzeugt wird, nicht an das vierte Schaltelement (34) überträgt;
basierend darauf, dass sich das vierte Schaltelement (34) im offenen Zustand befindet, Ansteuern eines dritten Schaltelements (33) in einen geschlossenen Zustand, Ansteuern eines zweiten Schaltelements (32) in einen geschlossenen Zustand und Empfangen einer ersten Spannung durch ein Relais (21);
Ansteuern des vierten Schaltelements (34) in einen geschlossenen Zustand, als Reaktion darauf, dass das Zeitverzögerungsmodul (51) das Ansteuersignal an das vierte Schaltelement (34) überträgt, nachdem eine bestimmte Zeitdauer verstrichen ist; und
basierend darauf, dass sich das vierte Schaltelement (34) im geschlossenen Zustand befindet, Ansteuern des dritten Schaltelements (33) in einen offenen Zustand, Ansteuern des zweiten Schaltelements (32) in einen offenen Zustand und Empfangen, durch das Relais (21), einer zweiten Spannung, die kleiner ist als die erste Spannung.

10. Verfahren zum Ansteuern eines Relay mit geringem Stromverbrauch nach Anspruch 9, wobei
das Relais
eine Versorgungsspannung empfängt, indem die Versorgungsspannung durch einen parallel zum zweiten Schaltelement verbundenen Widerstand geteilt wird, als Reaktion darauf, dass das zweite Schaltelement in einen offenen Zustand angesteuert wird.

11. Relaisvorrichtung mit geringem Stromverbrauch nach Anspruch 1, wobei die Vorrichtung konfiguriert ist zum:
Ansteuern in einem ersten Ansteuerzustand für eine bestimmte Zeitdauer nach einem Zeitpunkt, zu dem das Ansteuersignal empfangen wird, und Ansteuern in einem zweiten Ansteuerzustand nach Ablauf der bestimmten Zeitdauer, und Anlegen einer ersten Spannung an das Relais während des ersten Ansteuerungszustands und Anlegen einer zweiten Spannung an das Relais während des zweiten Ansteuerungszustands,
wobei die zweite Spannung kleiner ist als die erste Spannung.

## Revendications

1. Dispositif de relais de faible puissance (1) comprenant: un relais (21) comportant une bobine et un élément de commutation;
un module de génération de signal (11) configuré pour générer un signal de commande; et un premier élément de commutation (31) connecté au module de génération de signal (11) et au relais (21);
**caractérisé en ce que**:
un deuxième élément de commutation (32) connecté entre le premier élément de commutation (31) et le relais (21), et connecté en parallèle à une résistance (41) pour régler la tension appliquée au relais (21);
un troisième élément de commutation (33) connecté au deuxième élément de commutation (32) et conçu pour amener le deuxième élément de commutation (32) à s'ouvrir/se fermer;
un quatrième élément de commutation (34) connecté au troisième élément de commutation (33) et conçu pour amener le troisième élément de commutation (33) à s'ouvrir/se fermer; et
un module de temporisation (51) connecté entre le quatrième élément de commutation (34) et le module de génération de signal (11) et permettant au quatrième élément de commutation (34) de se fermer dès que le premier élément de commutation (31) se ferme.

2. Dispositif de relais de faible puissance selon la revendication 1, dans lequel
le dispositif de relais de faible puissance lorsqu'il se trouve dans un état initial avant de recevoir le signal de commande, fonctionne dans un premier état de commande pendant une durée déterminée dès qu'il reçoit le signal de commande, et fonctionne dans un deuxième état de commande une fois la durée écoulée.

3. Dispositif de relais de faible puissance selon la revendication 2, dans lequel
le relais reçoit une première tension pendant le premier état de commande, et reçoit une deuxième tension dont la valeur est inférieure à celle de la première tension pendant le deuxième état de commande.

4. Dispositif de relais de faible puissance selon la revendication 2, dans lequel
le quatrième élément de commutation est ouvert à l'état initial et reste ouvert dans le premier état de commande, puis se ferme dans le deuxième état de commande.

5. Dispositif de relais de faible puissance selon la revendication 2, dans lequel
le premier élément de commutation est ouvert à l'état initial et reste ouvert dans le premier état de commande, puis se ferme dans le deuxième état de commande.

6. Dispositif de relais de faible puissance selon la revendication 2, dans lequel
le troisième élément de commutation est fermé à l'état initial et reste fermé dans le premier état de commande, puis s'ouvre dans le deuxième état de commande.

7. Dispositif de relais de faible puissance selon la revendication 2, dans lequel
le deuxième élément de commutation est fermé à l'état initial et reste fermé dans le premier état de commande, puis s'ouvre dans le deuxième état de commande.

8. Dispositif de relais de faible puissance selon la revendication 1, dans lequel
le module de temporisation permet d'ouvrir le deuxième élément de commutation après une certaine durée de temps suivant la fermeture du premier élément de commutation.

9. Procédé de commande de relais de faible puissance pour commander le dispositif de relais de faible puissance (1) selon la revendication 1, le procédé comprenant:
le fait d'amener le premier élément de commutation (31) à se fermer en réponse à un signal de commande généré par un module de génération de signal (11);
le fait d'amener le quatrième élément de commutation (34) à s'ouvrir, sur la base du fait que le module de temporisation (51) ne transmet pas le signal de commande au quatrième élément de commutation (34) pendant une certaine durée dès que le signal de commande est généré;
sur le base du fait que le quatrième élément de commutation (34) est à l'état ouvert, le fait d'amener le troisième élément de commutation (33) à se fermer, puis le fait d'amener le deuxième élément de commutation (32) à se fermer, et la réception, par un relais (21), d'une première tension;
le fait d'amener le quatrième élément de commutation (34) à se fermer en réponse au fait que le module de temporisation (51) transmet le signal de commande au quatrième élément de commutation (34) une fois qu'un certain laps de temps s'est écoulé; et
sur le base du fait que le quatrième élément de commutation (34) est à l'état fermé, le fait d'amener le troisième élément de commutation (33) à s'ouvrir, puis le fait d'amener le deuxième élément de commutation (32) à s'ouvrir, et la réception, par un relais (21), d'une seconde tension.

10. Dispositif de relais de faible puissance selon la revendication 9, dans lequel
le relais
reçoit une tension d'alimentation obtenue par division de la tension d'alimentation avec une résistance connectée en parallèle au deuxième élément de commutation; dès que le deuxième élément de commutation passe à l'état ouvert.

11. Dispositif de relais de faible puissance selon la revendication 1, dans lequel le dispositif est configuré pour:
fonctionner dans un premier état de commande pendant une certaine durée à compter du moment où le signal de commande est reçu, puis fonctionner dans un deuxième état de commande une fois la durée écoulée, et
appliquer une première tension au relais pendant le premier état de commande et appliquer une seconde tension au relais pendant le deuxième état de commande,
dans lequel la seconde tension est inférieure à la première tension.
